# EUROPEAN PATENT APPLICATION

(11) **EP 1 684 417 A2**
(43) Date of publication of application: **26.07.2006**
(21) Application number: 06009630.2
(22) Date of filing: 17.03.2000
(51) Int. Cl.: H03F 1/32, H04L 27/36

(54) **Method of operating a radio frequency transmitter and apparatus for controlling a radio frequency transmitter**

(30) Priority: 19.03.1999 GB 9906417
(62) Divisional of application: 00911071.9
(71) Applicant: Sepura Limited, Cambridge CB4 1GR (GB)
(72) Inventor: Rayne, Mark Wentworth, Stretham Nr. Ely Cambridgeshire CB6 3ND (GB)
(74) Representative: Tothill, John Paul

(57) **Abstract**

A mobile radio communications system in which mobile radio units of the system determine the appropriate feedback parameters to achieve desired operation of their power amplifiers by making trial transmissions under their desired output conditions. The radio system provides the mobile radio units with periodic opportunities to make such trial transmissions in the form of timeslots (S1, S2 and S3), spaced at regular intervals. A mobile radio unit transmits in timeslot (S1) a trial signal at power setting (P1), measures the performance of this amplifier, and derives therefrom the corresponding control parameters for that power level and stores them. In the next timeslot (S2), the mobile radio unit transmits a trial signal at a second, different power level (P2), and again computes and stores the control parameters for that power level. The mobile radio unit is then ready to transmit at either power level (P1) or lower level (P2).

## Description

The present invention relates to radio transmitters and in particular to the operation of radio-frequency (RF) amplifiers in radio transmitters of a mobile radio communications system.

Some mobile radio communications systems, such as the TETRA (TErrestrial Trunked RAdio) system require the use of radio transmitters having relatively highly linear and stable RF power amplifier arrangements. This can be because of the radio modulation scheme which is used, and/or to help reduce interference on adjacent radio channels, etc., as is known in the art.

Such amplifier arrangements use techniques such as predistortion of the input signal to compensate for amplifier induced distortions to the signal, or feedback arrangements (such as in polar loop and Cartesian loop amplifiers), to try to ensure that the amplifier operates in the desired manner. In these techniques it is important to use the correct amount of predistortion or feedback so that the desired output is achieved. Typically, there will be a number of parameters or variables which are used to control the amount of predistortion or feedback applied to the amplifier. These control, e.g. feedback loop, parameters (which are often, as is known in the art, referred to loosely as "linearisation parameters") should be set so as to control the amplifier arrangement to operate in the desired optimum manner. In general it is important in such amplifier arrangements to achieve the correct phase and amplitude (gain) control.

However, the gain and phase characteristics of RF amplifiers depend on a number of factors such as operating temperature, supply voltage, transmission frequency and output power level, i.e. the operating conditions of the amplifier. Thus, for example, for each different output power level at which the amplifier is required to operate, a different set of amplifier control parameters (e.g. for varying temperature and supply voltage conditions) is required. One could attempt to store all possible values of the control parameters for each e.g. power setting and temperature setting, but this is not durable or even possible due to the number of stored values that would be required.

In practice therefore it is usual in mobile radio communications systems which use transmitters having linear RF amplifiers to attempt to derive the relevant control parameters in an effectively real-time manner as and when a transmission is desired. This is typically done by the transmitter first, making a trial control transmission at the intended output power. The performance of the amplifier for that trial transmission is measured and appropriate control parameters for the amplifier under those conditions derived (e.g. by considering the error in the measured amplifier performance). The derived control parameters can then be applied to the transmitter's amplifier when making a transmission at the tested power level. By repeating this process at frequent intervals the transmitter is able to maintain itself ready to transmit at the tested power setting, despite any changes in its other operating conditions, such as its temperature.

In such arrangements the radio system typically provides so-called "linearisation" opportunities for transmitters of the system (e.g. in mobile radio units) to make their trial transmissions for amplifier control without interfering with other users of the radio system. In time division multiple access (TDMA) radio systems, for example, these trial transmission opportunities may arise in every timeslot, or, as is the case in the TETRA system, there may be dedicated "linearisisation" timeslots that occur at intervals in which e,g. mobile radio units are permitted to make their trial transmissions.

The Applicants have recognised that a problem with the above systems is that if the transmitter, e.g. mobile radio unit, is required to change its output settings, e.g. output power level, it should optimise its amplifier at that power setting before it transmits (as if it were to transmit at the new power level before it has optimised its amplifier, the transmitter might emit spurious radio signals which could interfere with other users, or in a more extreme case its amplifier could become unstable). In practice the transmitter has to wait for another trial transmission opportunity (e,g. linearisation timeslot) to be provided by the radio system before it can ready itself to transmit at the now power level. This may be undesirable, particularly if those opportunities only arrive at spaced intervals (as is the case in the TETRA system, where linearisation timeslots may only occur every 1.02 seconds).

One situation that the Applicants have recognised where it would be desirable for a transmitter of a mobile radio unit to be able to change its transmit power level rapidly is in mobile radio systems, such as TETRA, where mobile radio units transmit initial random access attempts to a fixed radio network when they wish to make a call. In such systems it is desirable for the mobile radio units when sending user traffic such as speech or other data, to operate at a power level just high enough to be received by their serving base station, e.g. for reasons of battery economy and interference limitation. On the other hand it is usually preferable for all mobile radio units to make their random access attempts at the same, higher power level than the user traffic transmissions, as this facilitates more efficient operation of the 'aloha' access mechanism for permitting the mobile radio unite to gain access to the radio system.

However, the Applicants have recognised that in practice in such systems mobile radio units usually have to make their random access attempts at the power level that they expect to use for traffic transmissions. This is because the mobile radio unit's amplifier should be optimised at its traffic transmission power level when it makes a random access attempt, since the base station could respond to that random access attempt by instructing the mobile unit to send its user traffic immediately, without first giving it a further trial transmission opportunity.

The Applicants have also recognised that in certain circumstancen it may be desirable for a mobile radio unit to make in a short time period successive transmissions at two different frequencies. This could be the case, for example, for a TETRA mobile radio unit which is operating in the direct mode (i.e. it is communicating with another mobile unit independently of a fixed radio network) but may wish also to communicate quickly with the fixed radio network. Such transmissions would take place at different frequencies.

However as noted above, transmission frequency affects the operation of an RF amplifier. Thus when operating at a different frequency the amplifier should be optimised at that frequency. This can lead to transmission delays where the mobile radio unit has to await a trial transmission opportunity before it can operate at the new frequency.

According to a first aspect of the present invention, there is provided a method of operating a radio frequency transmitter which includes an RF amplifier, the method comprizing the transmitter:
making trial transmissions at each of two or more different values of a particular operating parameter of the transmitter;
measuring the performance of the amplifier during each trial transmission;
deriving control parameters for the amplifier at each operating parameter value on the basis of the measured performance of the amplifier;
storing the derived control parameters; and
transmitting at one of the particular operating parameter values while using the stored control parameters for that operating parameter value to control the amplifier's operation during that transmission.

According to a second aspect of the present invention, there is provided an apparatus for controlling a radio frequency transmitter which transmitter includes an RF amplifier, the apparatus comprising:
means for causing the transmitter to make a trial transmission at each of two or more different values of a particular operating parameter of the transmitter;
means for measuring the performance of the transmitter's RF amplifier during each trial transmission;
means for deriving control parameters for the amplifier at each trial operating parameter value on the basis of the measured performance of the amplifier;
means for storing the derived control parameters, such that the apparatus has stored at the same time control parameters derived from the two or more trial transmissions; and
means for causing the transmitter to transmit at one of the particular operating parameter values while using the stored control parameters for that operating parameter value to control the amplifier's operation during that transmission.

In the present invention the radio transmitter makes trial transmissions at two or more different values of a particular operating parameter of the transmitter (such as output power level or frequency) and derives from those tests control parameters which are then stored for future use to control the transmitter's amplifier when transmitting at the relevant operating parameter value. This provides a more flexible arrangement where the transmitter can be ready to transmit at two or more different operating parameter values without the need to wait for further trial transmission opportunities, and without the need to store in the transmitter large numbers of control parameters for all expected possible operating conditions. In effect the necessary control parameters for correct operation of the transmitter for two or more different operating parameter values are derived in a real-time manner and stored- The transmitter then has stored simultaneously suitable control parameters for operation at the tested operating parameter values under the transmitter's current other operating (e.g. input and environmental) conditions.

Preferably, the transmitter stores only control parameters derived from the trial transmissions (i.e. it does not store independently predetermined amplifier control parameters not derived in use by making trial transmissions), as this reduces the amount of data that needs to be stored.

In a particularly preferred embodiment only control parameters derived from a few, e.g. not more than three, and preferably two or three, trial transmissions (preferably made at different operating or output parameter values) are stored at any one time. Most preferably only control parameters derived from the last few, e.g. the last two or last three (different operating or output parameter value) trial transmissions made by the transmitter are stored at any one time. This reduces the amount of data stored and could be .. done, for example, on a first in first out basis, with the latest data replacing the oldest in the memory.

Thus, for example, in an embodiment of the present invention a transmitter would make trial transmissions at two different operating parameters, e.g. output power level, values, and derive and store the corresponding amplifier control parameters. The transmitter can then, without the need for further trial transmissions, transmit at the first tested parameter value using the appropriate stored amplifier control parameters and then transmit at the second tested parameter value using the other stored, amplifier control parameters. Indeed, the transmitter may in practice quite often operate in this manner.

Thus it can be seen that in the present invention, unlike in usual amplifier control parameter deriving techniques, trial transmissions arc made and corresponding control parameters derived for operating conditions which the transmitter may not expect to operate under for its next transmission. Also, in the present invention control parameters derived from a trial transmission made previously and at different operating conditions to the last such trial transmission (and indeed different to the last non-trial transmission) can be and will often be used to control the amplifier of the transmitter.

The trial transmissions should take an appropriate form, e.g. be of a predetermizied training sequence, so that the amplifier's performance can be measured, as is known in the art. The particular operating parameter and its values for the trial transmissions can be selected as desired. AS many different values as desired can be tested, although the more that are tested, the more complex the signal processing. Preferably therefore only two or three and moot preferably only two, different operating parameter values are tested.

The trial transmissions preferably take place at different values of a particular output parameter of the transmitter, the value of which parameter can be controlled and selected, such as the output power or frequency of the transmitter. In this arrangement, the necessary control parameters for operation at the selected different output parameter values under the transmitter's current other operating (e.g. input and environmental) conditions are derived. The transmitter can then be ready Cor immediate operation at one of the selected output parameter values in its current operating environment. The trial transmissions therefore most preferably take place at values of the output parameter or parameters that the transmitter expects to use or considers that it could conceivably use, in the near future, e.g., in a subsequent predetermined time period, and/or use for its next, or for its next or next but one, or for its next or next but one or next but two, "normal" (i.e., non-trial) transmission.

In a preferred embodiment only a single operating, e.g. output parameter is varied for each trial transmission, with the other operating conditions not being changed (at least not deliberately).

In a particularly preferred embodiment, the trial transmissions take place at two or more different output power levels, preferably with the remaining operating conditions being maintained au far as possible substantially constant. In effect the transmitter .. derives its control parameters for the two or more different output power levels at its current other operating conditions (e.g. temperature, supply voltage, and transmission frequency). This permits the transmitter to be ready to transmit at two different power levels without the need to wait for a new trial transmission opportunity before switching power levels. Thus the transmitter can transmit a random access attempt at one power level, and substantially immediately transmit user traffic at a different power level. Thus preferably the trial transmissions take place at two different power levels, one being the expected desired power level for user traffic transmissions and the other being the desired power level for random access attempts, e.g. the maximum permitted transmission power level of the transmitter.

Thus according to a third aspect of the present: invention, there is provided a method of operating a mobile radio unit of a mobile radio communications system, which mobile radio unit includes a radio frequency transmitter which includes an RF amplifier, comprising the mobile radio unit:
making trial transmissions at a first output power level and at a second different output power level;
measuring the performance of the amplifier of the mobile radio unit during each trial transmission;
deriving control parameters for the amplifier at each output power level on the basis of the measured performance of the amplifier;
storing the derived control parameters; and
transmitting to a base station of the system at the first output power level using the stored control parameters derived for that output power level to control the amplifier's operation during that transmission, and transmitting to the base station of the system at the second output power level using the stored control parameters derived for that output power level to control the amplifier's operation during that transmission, without making a trial transmission between the transmissions to the base station.

In this aspect: of the invention, the trial transmissions would also often be performed without the mobile radio unit making any transmission to a base station of the mobile radio communications system between the trial transmissions.

In another preferred embodiment, the trial transmissions take place at different transmission frequencies, with the remaining operating parameters preferably being kept substantially constant. Again the frequencies should be selected appropriately. Thus in another aspect of the invention, the mobile radio unit operates in a similar manner to the above third aspect of the invention, but the trial transmissions and the transmissions to the base station take place at different frequencies (rather than, or in addition to, them being at: different power levels). In an alternative such arrangement:, the mobile radio unit makes transmissions to another mobile radio unit directly (i.e. independently of the fixed radio network) and to a base station at different frequencies (and, optionally, at different power levels), without making an intermediate trial transmission.

In another preferred embodiment, two trial transmissions are made, one at a first power level and a first frequency and one at a second power level and a second frequency.

In a particularly preferred embodiment, three trial transmissions are made, one at a first power level and a first frequency, one at a second power level and the first frequency, and one at a third power level and a second frequency, and appropriate control parameters derived and stored. In this arrangement the third power level could differ from the first and second power levels, but could also be the same as one of those power levels. This arrangement is particularly applicable to a TETRA mobile radio unit operating in the direct mode, since the mobile radio unit can then be ready to transmit random access and user traffic to the fixed radio network at the first frequency and also to transmit in direct mode to another mobile radio unit at the second frequency. In this situation the mobile radio unit would typically spend much of its time receiving on the second (direct mode) frequency, but there would be predetermined opportunities (the timing of which mobile unit would be aware of) for it to transmit to the fixed network on the first frequency. When operating in accordance with this embodiment of the present invention, the mobile unit would be able to switch directly to transmitting on the first frequency when one of the predetermined opportunities to do so arisen.

The trial transmissions at the different operating conditions should be made successively. They may each be made in separate trial transmission opportunities, e.g. in immediately successive trial transmission opportunities (e.g. timeslots). In a particularly preferred embodiment, the trial transmissions are made successively in the same trial transmission opportunity (e.g. linearisation timeslot). This latter arrangement enables the transmitter to prepare itself for transmitting at any one of a number of different output conditions, e.g. power levels or frequencies, after only one trial transmission opportunity.

Preferably the trial transmissions are repeated periodically, e.g. at every trial transmission opportunity as appropriate, so that the transmitter can refresh its stored control parameters and always be ready to transmit at e.g. the selected power levels and/or frequencies, at its then current other operating conditions. In a particularly preferred embodiment the transmitter or apparatus repeats periodically a predetermined cycle of trial transmissions at varying operating conditions and derives and stores the corresponding control parameters. The trial transmission cycle could be repeated at e.g. predetermined time intervals or simply as and when it becomes possible to make the trial transmissions (i.e. appropriate trial transmission opportunities, e.g. timeslots, arrive). The cycle could, for example, comprise making a transmission at a first predetermined power level and then making a transmission at a second predetermined power level. That cycle would then be repeated as appropriate.

The amplifier's performance during each trial transmission should be measured as appropriate to determine how accurately the amplifier is performing. The control parameters should then be derived from the amplifier's performance appropriately. For example the error in the amplifier's performance can be used to derive corrections to the amplifier control (e.g. feedback) parameters used during the trial transmission to improve the performance of the amplifier, and thereby to derive the control parameter to use for that operating condition. These steps can be done in any appropriate manner known in the art. Suitable techniques are described in, for example, WO98/00908, and the Applicant's UK patent application GB-A-2341503.

The calculations, etc. to derive the control parameters may be performed during the trial transmission or the trial transmission opportunity (e.g. timeslot) in which the trial transmission is made (once enough measurements have been made), or they may be performed subsequently. The derived control parameters for each tested operating condition, e.g. output power level, are then stored (such that the transmitter has stored at the same time derived control parameters for two or more different operating conditions) .

In this way the radio transmitter is ready to transmit at any one of a number of different operating conditions, e.g. output power levels and/or frequencies and does not have to wait until a new trial transmission opportunity before changing its output parameters e.g. power level or frequency.

The methods in accordance with the present invention may be implemented at least partially using software e.g. computer programs. It will thus be seen that when viewed from further aspects the present invention provides computer software opecifically adapted to carry out the methods hereinabove described when installed on data processing means, and a computer program element comprising computer software code portions for performing the methods hereinabove described when the program element is run on a computer. The invention also extends to a computer software carrier comprising such software which when used to operate a radio system comprising a digital computer causes in conjunction with said computer said system to carry out the steps of the method of the present invention. Such a computer software carrier could be a physical storage medium such as a ROM chip, CD ROM or disk, or could be a signal such as an electronic signal over wires, an optical signal or a radio signal such as to a satellite or the like.

It will further be appreciated that not all steps of the method of the invention need be carried out by computer software and thus from a further broad aspect the present invention provides computer software and such software installed on a computer software carrier for carrying out at least one of the steps of the methods set out hereinabove.

A number of preferred embodiments of the present invention will now be described by way of example only, and with reference to the accompanying drawings, in which:
Figure 1 shows schematically a Cartesian loop RF amplifier;
Figure 2 illustrates the operation of a mobile radio unit in accordance with a first embodiment of the present invention;
Figures 3 and 4 illustrate the operation of am mobile radio unit in accordance with a second embodiment of the present invention.

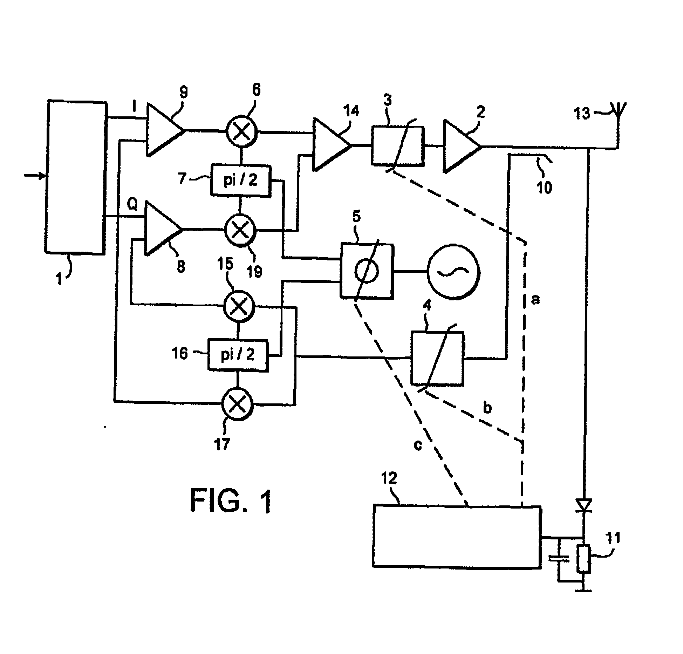

Figure 1 illustrates a radio transmitter, which includes Cartesian loop linear RF amplifier, such as might be used in a mobile radio unit of a mobile radio communications system, such as the TETRA system.

The input signal to the transmitter (i.e. the signal to be amplified and transmitted) is converted into real and imaginary components I and Q in convertor 1. These components are amplified up to radio frequency by RF amplifier 2. other components of the transmitter include variable attenuators 3, 4, signal splitter and phase adjuster 5, mixers 6, 15, 17, 19, phase splitters 7, 16, difference amplifiers 8, 9, directional coupler 10, signal detector 11, digital signal processor 12, summing amplifier 14 and radio antenna 13, as is known in the art.

The transmitter of Figure 1 should, as is known in the art, be operated to try to ensure that the output signal transmitted by the antenna 13 is a faithful reproduction of the input signal to the transmitter, i.e. that the transmitter operates in a linear manner. The amplifier arrangement of the transmitter is controlled by a feedback circuit whose effect can be adjusted by varying the feedback circuit control parameters a, b and c under the control or digital signal processor 12, to try to achieve this.

As discussed above, the appropriate feedback parameters a, b and c to achieve desired (e.g. stable) operation of the amplifier arrangement can be determined by making a trial transmission under the desired output conditions and assessing how closely that output transmission matches the input signal. By measuring the performance of the amplifier during the trial transmission, the control parameters a, b and c to use to ensure that the transmitter operates in the desired manner under those conditions can be derived. Those control parameters can then be stored in a memory and used subsequently to control operation of the amplifier of the transmitter when transmitting a signal under the corresponding conditions to try to ensure that it operates in the desired manner.

The control parameters could, for example, relate to the feedback loop phase adjustment, in which case the trial transmission could, for example, comprise a plain carrier signal. Alternatively or additionally the control parameters could, for example, relate to the modulation accuracy or balance provided by the amplifier, e.g. to the 10 balance, DC nulling and/or quadrature adjustment of the amplifier. In this latter case, a single sideband tone (e.g. at 2.25kHz) could be used, for example, for the trial transmission.

As discussed above, in many radio systems, such as the TETRA system, mobile radio units are periodically provided with opportunities to make trial transmissions and derive the necessary control parameters therefrom. In time division multiple access (TDMA) systems such as TETRA, these trial transmission opportunities are typically presented in the form of regular, predetermined "linearisation" timeslots.

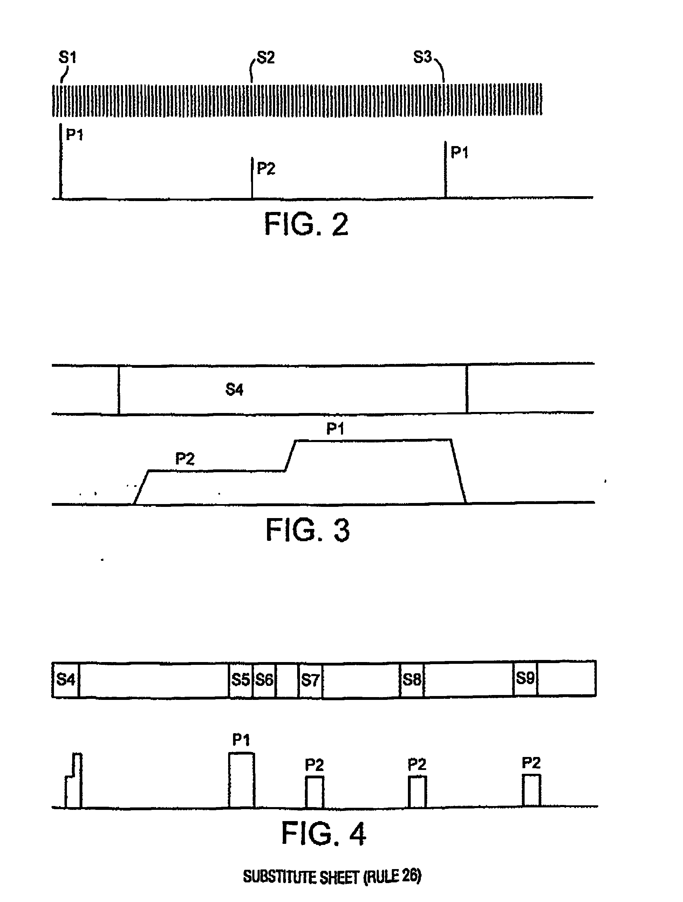

Figure 2 shows a series of TDMA timeslots, with socalled "linearisation" timeslots, i.e. trial transmission opportunities, S1, S2 and S3, spaced at regular, approximately one second, intervals. In accordance with the present invention, a mobile radio unit using, for example, a Cartesian loop RF amplifier such as that illustrated in Figure 1, would in linearisation timeslot S1. transmit a trial signal at power setting P1, as illustrated in Figure 2, and measure the performance of its amplifier. After the end of (or during) timeslot S1, the mobile radio unit uses the measured performance of its amplifier to derive the corresponding control parameters a₁, b₁ and c₁. (The trial signal and calculation may be as described in WO98/00908, for example.) The mobile radio unit is then ready to transmit at power level P1. P1 could, for example, comprise the maximum transmit power level that the mobile radio unit is permitted to use.

In the next linearisation timeslot S2, the mobile radio unit transmits a trial signal at a second, different power level P2, and again computes and stores the control parameters a₂, b₂ and c₂ for this power level after the end of (or during) S2. P2 could, for example, comprise the power level desired for user traffic, e.g. speech or other data, transmissions.

The mobile radio unit is now ready to transmit on either power level P1 or power level P2. It can therefore make a random access attempt at: power level P1, and then switch to power level P2 to send its user traffic without having to wait for another linearisation timeslot to occur (and without having to make a further trial transmission).

The mobile radio unit preferably continually repeats its cycle of trial transmissions and calculations; at different powers in successive linearisation timeslots. Thus preferably in linearisation timeslot S3 the mobile radio unit again makes a trial transmission at power level P1 and recomputes a₁, b₁ and c₁.

Figure 3 illustrates a second embodiment of the present invention. In this arrangement the radio unit performs its trial transmissions at the two different power levels P1 and P2 within a single trial transmission opportunity, i.e. linearisation timeslot, S4. (If desired trial transmissions at more than two different power levels could be carried out in the single trial transmission opportunity.) The mobile radio unit first transmits its test signal at the lower power setting P2 and measures its performance. It then increases its power output to P1 and repeats the measurements. The test transmissions could, of course, be transmitted the other way round (i.e. at power level P1 before power level P2, if desired). After the end of (or during) the linearisation timeslot S4, the mobile unit derives the required control parameters a₂, b₂ and c₂ for power setting P2 and the control parameters a₁, b₁ and c₁ for power level P1 and stores them.

Figure 4 shows how a mobile radio unit operating in accordance with the above embodiment of the present invention can adjust its transmission power level without waiting for a linearisation timeslot. The mobile radio unit firstly makes its trial transmissions for power levels P1 and P2 in linearisation timeslot n4, as described above in relation to Figure 3. Subsequently in random access timeslot SS, the mobile radio unit makes a random access attempt at power setting P1. To operate at power setting P1, the mobile radio unit sets its output power level to P1 and uses the derived and stored control parameters a₁, b₁ and c₁ as its feedback controls.

After the random access attempt, consider that the mobile radio unit receives in timeslot S6 a reply from the base station allocating it slots S7, S8 and S9 and beyond to transmit its user traffic. These slots all arrive before the next linearisation timeslot. The mobile radio unit accordingly sets its output power level to P2, sets its feedback controls to the derived and stored values a₂, b₂ and c₂ and then in slot S7 sends its user traffic at power level P2, It sends further user traffic in clots S8 and S9, again at power level P2.

It should be noted that the mobile radio unit does not have to wait for another trial transmission opportunity to make a trial transmission at power level P2 before it transmits its user traffic (which could induce a delay in the TETRA system of up to one second), but instead uses stored control parameter values derived from a trial transmission in a previous linearisation timeslot. Thus a mobile radio unit using a linear amplifier and operating in accordance with the present invention may transmit at different power settings without waiting for a trial transmission opportunity before changing its power level. It can also transmit satisfactorily at a different power level to the level used for the immediately preceding trial transmission.

Where a mobile radio unit wishes to operate at different output frequencies, it can operate in a similar manner to that described above. Thus it would in succesive or the same linearisation timeslots make trial transmissions at the relevant frequencies and derive appropriate amplifier control parameters which can then be stored for future use. As discussed above, it may desirable for a mobile radio unit to switch between frequencies without the need to wait for a linearisation timeslot. One arrangement where this would occur is when a TETRA mobile radio is operating in the TETRA direct mode and it still desires to be in communication with the fixed radio network.

Although the above embodiments have been described with particular reference to mobile radio units of the TETRA radio system, the present invention is, as will be appreciated by those skilled in the art, applicable to other mobile radio systems, and in particular to any mobile radio system which uses linear RF amplifiers and in particular to such a system which is a TDMA system and provides predetermined timeslots for mobile radio units to make trial transmissions. Although particularly applicable to the operation of mobile radio units, the present invention can be used to control the operation ot any transmitter of a mobile radio system, e.g. including base stations, if desired.

## Claims

1. A method of operating a radio frequency transmitter which includes an RF amplifier, the method comprising the transmitter:
making trial transmissions at each of two or more different values of a particular operating parameter of the transmitter;
measuring the performance of the amplifier during each trial transmission;
deriving control parameters for the amplifier at each operating parameter value on the basis of the measured performance of the amplifier;
storing the derived control parameters; and
transmitting at one of the particular operating parameter values while using the stored control parameters for that operating parameter value to control the amplifier's operation during that transmission; the method being **characterised by**:
the trial transmissions taking place at two or more different transmission frequencies; and by
the transmitter storing the derived control parameters such that the transmitter has stored at the same time control parameters derived from the two or more trial transmissions and can use any of the stored control parameters for controlling the operation of the amplifier when making a transmission.

2. The method of claim 1, wherein only a single operating parameter is varied for the trial transmissions, with the other operating parameters being kept the same.

3. The method of claim 1 or 2, comprising maintaining the remaining operating parameters of the amplifier substantially constant during the trial transmissions.

4. A method of operating a mobile radio unit of a mobile radio communications system, which mobile radio unit includes a radio frequency transmitter which includes an RF amplifier, comprising the mobile radio unit:
making trial transmissions at a first transmission frequency and at a second different transmission frequency;
measuring the performance of the amplifier of the mobile radio unit during each trial transmission;
deriving control parameters for the amplifier at each transmission frequency on the basis of the measured performance of the amplifier;
storing the derived control parameters; and
transmitting to a base station of the system at the first transmission frequency using the stored control parameters derived for that transmission frequency to control the amplifier's operation during that transmission, and transmitting to the base station of the system at the second transmission frequency using the stored control parameters derived for that transmission frequency to control the amplifier's operation during that transmission, without making a trial transmission between the transmissions to the base station.

5. A method of operating a mobile radio unit of a mobile radio communications system, which mobile radio unit includes a radio frequency transmitter which includes an RF amplifier, comprising the mobile radio unit:
making trial transmissions at a first transmission frequency and at a second different transmission frequency;
measuring the performance of the amplifier of the mobile radio unit during each trial transmission;
deriving control parameters for the amplifier at each transmission frequency on the basis of the measured performance of the amplifier;
storing the derived control parameters; and
transmitting to a base station of the system at the first transmission frequency using the stored control parameters derived for that transmission frequency to control the amplifier's operation during that transmission, and transmitting to a mobile radio unit of the system at the second transmission frequency using the stored control parameters derived for that transmission frequency to control the amplifier's operation during that transmission, without making a trial transmission between the transmissions to the base station and the mobile radio unit.

6. The method of any one of the preceding claims, wherein the trial transmissions are repeated periodically.

7. The method of claim 6, wherein the transmitter or mobile radio unit repeats periodically a predetermined cycle of trial transmissions at selected, different operating conditions.

8. The method of any one of the preceding claims, wherein the radio frequency transmitter or mobile radio unit is for use in a radio communications system which provides spaced predetermined trial transmission opportunities for transmitters to make their trial transmissions, and wherein the transmitter or mobile radio unit makes two or more of its trial transmissions successively in the same trial transmission opportunity.

9. The method of any one of the preceding claims, wherein only control parameters derived from the last two or three trial transmissions made by the transmitter are stored at any one time.

10. The method of any one of the preceding claims,
wherein the trial transmissions take place at output parameter values that the transmitter expects to use for its next or next but one or next but two non-trial transmission.

11. An apparatus for controlling a radio frequency transmitter which transmitter includes an RF amplifier, the apparatus comprising:
means for causing the transmitter to make a trial transmission at each of two or more different transmission frequencies of the transmitter;
means for measuring the performance of the transmitter's RP amplifier during each trial transmission;
means for deriving control parameters for the amplifier at each trial operating parameter value on the basis of the measured performance of the amplifier;
means for storing the derived control parameters; and
means for causing the transmitter to transmit at one of the particular operating parameter values while using the stored control parameters for that operating parameter value to control the amplifier's operation during that transmission; the apparatus being **characterised by** comprising:
means for storing the derived control parameters such that the apparatus has stored at the same time control parameters derived from the two or more trial transmissions and can use any of the stored control parameters for controlling the operation of the amplifier when making a transmission.

12. The apparatus of claim 11, comprising means for repeating periodically a predetermined cycle of trial transmissions at selected different operating conditions.

13. The apparatus of claim 11 or 12, wherein the storing means is arranged to store only control parameters derived from the last two or three trial transmissions made by the transmitter at any one time.

14. The apparatus of any one of claims 11 to 13, wherein the means for causing the transmitter to make a trial transmission comprises means for causing the transmitter to make trial transmissions at output parameter values that the transmitter expects to use for its next or next but one or next but two non-trial transmission.

15. A mobile radio unit for use in a mobile radio communications system comprising the apparatus of any one of claims 11 to 14.

16. A computer program element comprising computer software code for performing the method of any one of claims 1 to 10 when the program element is run on a computer.
